# FASCICULE DE BREVET EUROPEEN

(11) **EP 4 008 020 B1**
(45) Date de publication et mention de la délivrance du brevet: **10.01.2024**
(21) Numéro de dépôt: 20747065.9
(22) Date de dépôt: 02.07.2020
(51) Int. Cl.: H01L 21/20, H01L 21/762

(54) **PROCEDE DE FABRICATION D'UNE STRUCTURE COMPOSITE COMPRENANT UNE COUCHE MINCE EN SIC MONOCRISTALLIN SUR UN SUBSTRAT SUPPORT EN SIC POLYCRISTALLIN**
VERFAHREN ZUR HERSTELLUNG EINER VERBUNDSTRUKTUR MIT EINER DÜNNEN SCHICHT AUS MONOKRISTALLINEM SIC AUF EINEM TRÄGERSUBSTRAT AUS POLYKRISTALLINEM SIC
METHOD FOR MANUFACTURING A COMPOSITE STRUCTURE COMPRISING A THIN LAYER OF MONOCRYSTALLINE SIC ON A CARRIER SUBSTRATE OF POLYCRYSTALLINE SIC

(30) Priorité: 01.08.2019 FR 1908840
(43) Date de publication de la demande: 08.06.2022
(73) Titulaire: SOITEC, 38190 Bernin (FR)
(72) Inventeur: SINQUIN, Yann, 38000 GRENOBLE (FR); BETHOUX, Jean-Marc, 38500 LA BUISSE (FR); RADISSON, Damien, 38420 LE VERSOUD (FR)
(74) Mandataire: IP Trust
(86) Numéro de dépôt international: PCT/FR2020/051159
(87) Numéro de publication internationale: WO 2021/019137

(56) Documents cités:
- EP-A1- 3 349 237
- EP-A2- 0 594 030
- US-A1- 2018 047 630

## Description

### DOMAINE DE L'INVENTION

La présente invention concerne le domaine des matériaux semi-conducteurs pour composants microélectroniques. Elle concerne en particulier un procédé de fabrication d'une structure composite comprenant une couche mince en carbure de silicium monocristallin sur un substrat support en carbure de silicium poly-cristallin.

### ARRIERE PLAN TECHNOLOGIQUE DE L'INVENTION

L'intérêt pour le carbure de silicium (SiC) a considérablement augmenté au cours des dernières années, car ce matériau semi-conducteur peut accroître la capacité de traitement de l'énergie. Le SiC est de plus en plus largement utilisé pour la fabrication de dispositifs de puissance innovants, pour répondre aux besoins de domaines montants de l'électronique, comme notamment les véhicules électriques.

Les dispositifs de puissance et les systèmes intégrés d'alimentation basés sur du carbure de silicium monocristallin peuvent gérer une densité de puissance beaucoup plus élevée par rapport à leurs homologues traditionnels en silicium, et ce avec des dimensions de zone active inférieures. Pour limiter encore les dimensions des dispositifs de puissance sur SiC, il est avantageux de fabriquer des composants verticaux plutôt que latéraux. Pour cela, une conduction électrique verticale, entre une électrode disposée en face avant de la structure SiC et une électrode disposée en face arrière, doit être autorisée par ladite structure.

Les substrats en SiC monocristallin destinés à l'industrie microélectronique restent néanmoins chers et difficiles à approvisionner en grande taille. Il est donc avantageux de recourir à des solutions de transfert de couches minces, pour élaborer des structures composites comprenant typiquement une couche mince en SiC monocristallin sur un substrat support plus bas coût. Une solution de transfert de couche mince bien connu est le procédé Smart Cut^{™}, basé sur une implantation d'ions légers et sur un assemblage par collage direct. Un tel procédé permet par exemple de fabriquer une structure composite comprenant une couche mince en SiC monocristallin (c-SiC), prélevée d'un substrat donneur en c-SiC, en contact direct avec un substrat support en SiC poly-cristallin (p-SiC), et autorisant une conduction électrique verticale. Il reste néanmoins difficile de réaliser un collage direct par adhésion moléculaire de bonne qualité entre deux substrats c-SiC et p-SiC, car la gestion de la rugosité et de l'état de surface desdits substrats est complexe.

Différentes méthodes dérivées de ce procédé sont également connues de l'état de la technique. Par exemple, F.Mu et al (ECS Transactions, 86 (5) 3-21, 2018) mettent en oeuvre un collage direct, après activation des surfaces à assembler par bombardement d'argon (SAB pour « Surface Activation bonding ») : un tel traitement préalable au collage génère une très forte densité de liaisons pendantes, lesquelles favorisent la formation de liaisons covalentes à l'interface d'assemblage, et donc une forte énergie de collage. Cette méthode présente néanmoins l'inconvénient de générer une couche amorphe, à la surface du substrat donneur en SiC monocristallin, qui impacte défavorablement la conduction électrique verticale entre la couche mince en c-SiC et le substrat support en p-SiC.

Des solutions ont été proposées pour résoudre ce problème, en particulier dans le document EP3168862, mettant en oeuvre une implantation d'espèces dopantes dans ladite couche amorphe, pour restaurer ses propriétés électriques. L'inconvénient principal de cette approche est sa complexité et donc son coût.

On connaît par ailleurs le document US8436363, qui décrit un procédé de fabrication d'une structure composite comprenant une couche mince en c-SiC disposée sur un substrat support métallique dont le coefficient de dilatation thermique est apparié avec celui de la couche mince. Ce procédé de fabrication comprend les étapes suivantes :
- la formation d'un plan fragile enterré dans un substrat donneur de c-SiC, délimitant une couche mince entre ledit plan fragile enterré et une surface avant du substrat donneur,
- le dépôt d'une couche métallique, par exemple en tungstène ou en molybdène, sur la surface avant du substrat donneur pour former le substrat support d'une épaisseur suffisante pour remplir le rôle de raidisseur,
- la séparation le long du plan fragile enterré, pour former d'une part, la structure composite comprenant le substrat support métallique et la couche mince en c-SiC, et d'autre part, le reste du substrat donneur en c-SiC.

Un tel procédé de fabrication n'est cependant pas compatible lorsque le matériau formant le substrat support est du p-SiC requérant un dépôt à des températures supérieures à 1000°C, par exemple à 1200°C : en effet, à ces températures élevées, la cinétique de croissance des cavités présentes dans le plan fragile enterré est plus rapide que la cinétique de croissance de la couche en p-SiC et l'épaisseur requise pour un effet raidisseur n'est pas atteinte avant l'apparition du phénomène de cloquage, lié à la déformation de la couche à l'aplomb des cavités.

Notons que la mise en oeuvre d'un dépôt de p-SiC à hautes températures (> 1000°C) est particulièrement avantageux en ce qu'il confère à la couche p-SiC déposée des propriétés structurelles (taille de grains, orientations cristallines, etc) favorables à une bonne conduction électrique, une bonne conduction thermique et à un coefficient de dilatation thermique très proche de celui du c-SiC : typiquement les propriétés attendues pour une structure à base de SiC destinée à recevoir des dispositifs de puissance. Les hautes températures de dépôt sont également avantageuses en ce qu'elles permettent des vitesses de croissance élevées

Le document US 2018/0047630 A1 décrit un procédé de fabrication d'une structure composite comprenant une couche mince en p-SiC disposée sur un substrat SiC , le procédé comprend les étapes suivantes : une formation d'un plan fragile enterré dans un substrat de c-SiC, une première étape de dépôt d'une couche p-SiC; une séparation le long du plan fragile enterré;une deuxième étape de dépôt d'une couche p-SiC.

Les document EP3349237 A1 et US 5471946 divulguent des autres procédés de fabrication d'une structure SiC.

### OBJET DE L'INVENTION

La présente invention concerne une solution alternative à celles de l'état de la technique, et vise à remédier à tout ou partie des inconvénients précités. Elle concerne en particulier un procédé de fabrication d'une structure composite comprenant une couche mince en c-SiC disposée sur un substrat support en p-SiC issu d'un dépôt à haute température.

### BREVE DESCRIPTION DE L'INVENTION

L'invention concerne un procédé de fabrication d'une structure composite comprenant une couche mince en carbure de silicium monocristallin disposée sur un substrat support en carbure de silicium poly-cristallin. Le procédé comprend :
- une étape de fourniture d'un substrat initial en carbure de silicium monocristallin,
- une première étape de dépôt à une température supérieure à 1000°C pour former une couche intermédiaire en carbure de silicium poly-cristallin sur le substrat initial, la couche intermédiaire présentant une épaisseur supérieure ou égale à 1,5 microns,
- une étape d'implantation ionique d'espèces légères à travers la couche intermédiaire, pour former un plan fragile enterré dans le substrat initial, délimitant la couche mince entre ledit plan fragile enterré et la couche intermédiaire,
- une deuxième étape de dépôt à une température supérieure à 1000°C pour former une couche additionnelle en carbure de silicium poly-cristallin sur la couche intermédiaire, ladite couche intermédiaire et la couche additionnelle formant le substrat support, une séparation le long du plan fragile enterré s'opérant au cours de la deuxième étape de dépôt.

Selon d'autres caractéristiques avantageuses et non limitatives de l'invention, prises seules ou selon toute combinaison techniquement réalisable :
- la première étape et la deuxième étape de dépôt sont réalisées par dépôt chimique en phase vapeur, à une température comprise entre 1000°C et 1600°C, préférentiellement entre 1200°C et 1600°C ;
- la première étape et la deuxième étape de dépôt sont réalisées à la même température ;
- la première étape et/ou la deuxième étape de dépôt sont réalisées à partir de précurseurs chlorés ;
- à l'issue de la première étape de dépôt, la couche intermédiaire présente une épaisseur supérieure ou égale à 3 microns, voire une épaisseur supérieure ou égale à 5 microns ;
- les espèces légères implantées sont choisies parmi l'hydrogène et/ou l'hélium ;
- l'implantation d'ions hydrogène est opérée à une énergie comprise entre 260 keV et 2000 keV, et à une dose comprise entre 5E16/cm² et 1E17/cm² ;
- le procédé comprend, avant la première étape de dépôt, une étape de préparation du substrat initial comportant au moins une désoxydation d'une surface avant dudit substrat initial ;
- le procédé comprend, après la deuxième étape de dépôt, des étapes de finition appliquées à la structure composite, lesdites étapes comportant un polissage mécano-chimique d'une face libre de la couche mince et/ou un polissage mécano-chimique d'une face libre du substrat support ;
- les polissages mécano-chimiques de la couche mince et du substrat support sont opérés simultanément en utilisant un équipement de polissage double-face.

### BREVE DESCRIPTION DES FIGURES

D'autres caractéristiques et avantages de l'invention ressortiront de la description détaillée de l'invention qui va suivre en référence aux figures annexées sur lesquelles :

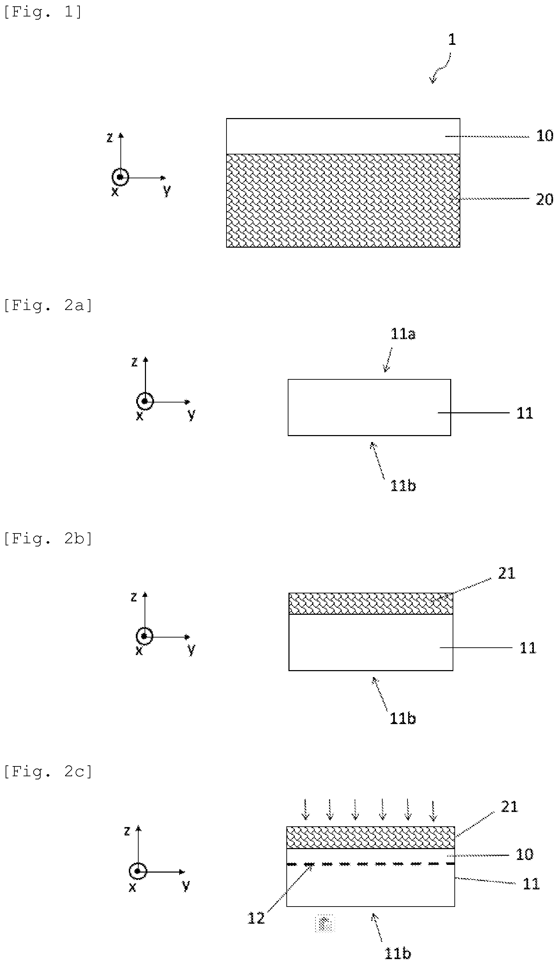

[Fig. 1] La figure 1 présente une structure composite élaborée selon un procédé de fabrication conforme à l'invention ;
[Fig. 2a]
[Fig. 2b]
[Fig. 2c]
[Fig. 2d]
[Fig. 2e]

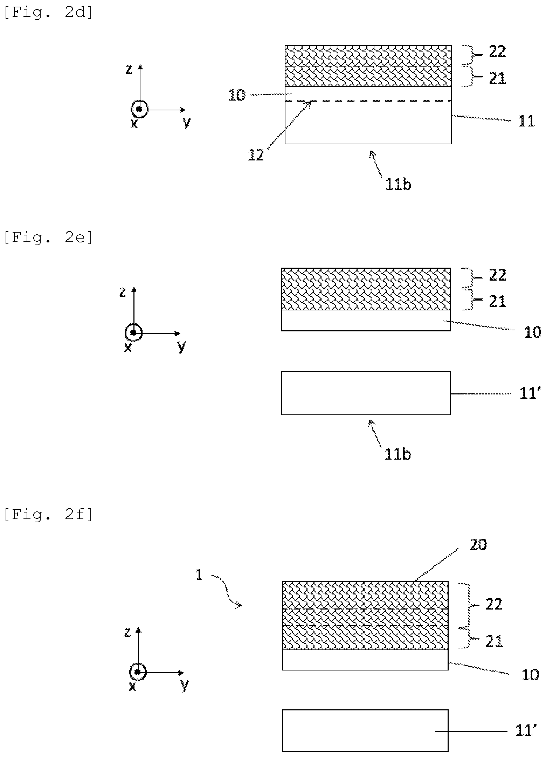

[Fig. 2f] Les figures 2a à 2f présentent des étapes d'un procédé de fabrication conforme à l'invention.

### DESCRIPTION DETAILLEE DE L'INVENTION

Dans la partie descriptive, les mêmes références sur les figures pourront être utilisées pour des éléments de même type. Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y ; et les épaisseurs relatives des couches entre elles ne sont pas nécessairement respectées sur les figures.

La présente invention concerne un procédé de fabrication d'une structure composite 1 comprenant une couche mince 10 en carbure de silicium monocristallin disposée sur un substrat support 20 en carbure de silicium poly-cristallin (figure 1).

Le procédé comprend en premier lieu une étape de fourniture d'un substrat initial 11 en carbure de silicium monocristallin (figure 2a). Dans la suite de la description, « c-SiC » sera utilisé pour parler de carbure de silicium monocristallin.

Le substrat initial 11 se présente préférentiellement sous la forme d'une plaquette de diamètre 100mm ou 150mm voire 200mm et d'épaisseur comprise typiquement entre 300 et 800 microns. Il présente une face avant 11a et une face arrière 11b. La rugosité de surface de la face avant 11a est avantageusement choisie inférieure à 1 nm Ra, rugosité moyenne (« average roughness ») mesurée par microscopie à force atomique (AFM) sur un scan de 20 microns x 20 microns.

La couche mince 10 en c-Si de la structure composite 1 sera formée, à l'issue du procédé de la présente invention, à partir du substrat initial 11 : ainsi, l'orientation cristallographique, la qualité cristalline ainsi que le niveau de dopage du substrat initial 11 sont choisis pour répondre aux spécifications requises des composants verticaux destinés à être élaborés sur la couche mince 10. Typiquement, le substrat initial 11 en c-SiC est de polytype 4H ou 6H, présentant une désorientation ("offcut") inférieure à 4.0° par rapport à l'axe cristallographique <11-20> ± 0.5°, et une densité de dislocations traversantes (« Micropipes ») inférieure ou égale à 5/cm², voire inférieure à 1/cm². Dopé de type N (azote), il présente une résistivité préférentiellement comprise entre 0.015 ohm.cm et 0.030 ohm.cm. De manière optionnelle, on pourra choisir un substrat initial 11 présentant une faible densité de dislocation de type BPD (« basal plane dislocation » selon la terminologie anglo-saxonne), typiquement inférieure ou égale à 1500/cm² selon la sensibilité des composants visés à ces défauts.

Alternativement, le substrat initial 11 peut comporter une couche superficielle sur sa face avant 11a, élaborée par exemple par épitaxie, et présentant les propriétés requises pour une future couche mince 10, laquelle sera formée, à l'issue du procédé de la présente invention, à partir de ladite couche superficielle.

Le procédé comprend une première étape de dépôt à une température supérieure à 1000°C pour former une couche intermédiaire 21 en p-SiC sur la face avant 11a du substrat initial 11 (figure 2b). La couche intermédiaire 21 présente une épaisseur supérieure à 1,5 microns. Avantageusement, l'épaisseur de la couche intermédiaire 21 est supérieure ou égale à 3 microns, voire supérieure ou égale à 5 microns. Cette épaisseur minimale est définie pour conférer à la couche intermédiaire 21 un rôle raidisseur suffisant au cours d'une deuxième étape ultérieure du procédé, comme cela sera décrit plus loin.

Préférentiellement, l'épaisseur de la couche intermédiaire 21 est maintenue inférieure à 30 microns, de manière à limiter l'énergie d'implantation requise pour traverser ladite couche, dans une prochaine étape du procédé.

Ce premier dépôt est avantageusement réalisé par une technique de dépôt chimique en phase vapeur (CVD), à base de précurseurs chlorés et à une température comprise entre 1000°C et 1600°C. Encore plus avantageusement, la température de dépôt est comprise entre 1200°C et 1600°C, comme proposé dans le document de Chichignoud et al (« Chlorinated silicon carbide CVD revisited for polycrystalline bulk growth », Volume 201, Issues 22-23, 25 September 2007, Pages 8888-8892, Surface and Coatings Technology). Les paramètres du premier dépôt sont déterminés de sorte que la couche intermédiaire 21 présente une bonne conductivité électrique, soit entre 0,015 et 0,03 ohm.cm, une haute conductivité thermique, soit supérieure ou égale à 200 W.m⁻¹.K⁻¹ et un coefficient de dilatation thermique similaire à celui de la couche mince 10, soit typiquement entre 3,8^{E}-6 /K et 4,2^{E}-6 /K à température ambiante.

Pour obtenir ces propriétés, la couche intermédiaire 21 pourra par exemple présenter les caractéristiques structurelles suivantes : grains de type 3C SiC, orientés 111, de taille moyenne 1 à 10µm, dopage de type N pour une résistivité finale inférieure ou égale à 0,03 ohm.cm.

Le procédé de fabrication selon l'invention comprend, en outre, une étape d'implantation ionique d'espèces légères à travers la couche intermédiaire 21, jusqu'à une profondeur déterminée dans le substrat initial 11. Cette implantation génère un plan fragile enterré 12 dans le substrat initial 11 (figure 2c).

Les espèces légères implantées sont _{!}Lii_{L}lli_{L}i_{'i'iiLi1!}L de l'hydrogène, de l'hélium ou une co-implantation de ces deux espèces. Comme cela est bien connu en référence au procédé Smart Cut^{™}, ces espèces légères vont former, autour de la profondeur déterminée, des microcavités distribuées dans une fine couche parallèle à la surface libre de la couche intermédiaire 21, soit parallèle au plan (x,y) sur les figures. On appelle cette fine couche le plan fragile enterré, par souci de simplification.

Le plan fragile enterré 12 délimite la future couche mince 10, avec la face avant du substrat initial 11. En d'autres termes, la couche mince 10 de la structure composite 1 qui sera obtenue à l'issue du procédé de fabrication est, à ce stade, disposée entre le plan fragile enterré 12 et la couche intermédiaire 21.

L'énergie d'implantation des espèces légères est choisie de manière à traverser la couche intermédiaire 21 et à atteindre la profondeur déterminée dans le substrat initial 11, ladite profondeur correspondant à une épaisseur visée de la couche mince 10.

Typiquement, des ions hydrogène seront implantés à une énergie comprise entre 260 keV et 2000 keV, et à une dose comprise entre 5E16/cm² et 1^{E}17/cm2, pour traverser une couche intermédiaire 21 de 1,5 micron à 30 microns et délimiter une couche mince 10 de l'ordre de 100 à 1500 nm.

Notons qu'une couche de protection pourra être déposée sur la face libre de la couche intermédiaire 21, préalablement à l'étape d'implantation ionique. Cette couche de protection peut être composée par un matériau tel que l'oxyde de silicium ou le nitrure de silicium par exemple.

Le procédé de fabrication comprend enfin une deuxième étape de dépôt à une température supérieure à 1000°C pour former une couche additionnelle 22 en p-SiC sur la couche intermédiaire 21 (figure 2d).

Le deuxième dépôt est avantageusement réalisé par une technique de dépôt chimique en phase vapeur (CVD), à base de précurseurs chlorés et à une température comprise entre 1000°C et 1600°C. Encore plus avantageusement, comme pour le premier dépôt, la température de dépôt est comprise entre 1200°C et 1600°C. De façon similaire au premier dépôt, les paramètres du deuxième dépôt sont déterminés de sorte que la couche additionnelle 22 présente une bonne conductivité électrique, soit entre 0,015 et 0,03 ohm.cm, une haute conductivité thermique, soit supérieure ou égale à 200 W.m⁻¹.K⁻¹ et un coefficient de dilatation thermique similaire à celui de la couche mince 10, soit typiquement entre 3,8^{E}-6 /K et 4,2^{E}-6 /K à température ambiante.

La température et les conditions du deuxième dépôt pourront être identiques ou différentes de celles du premier dépôt, l'objectif étant que les propriétés électriques, thermiques et mécaniques de la couche additionnelle 22 mentionnées ci-dessus soient obtenues.

Comme énoncé précédemment pour la couche intermédiaire 21, pour obtenir ces propriétés, la couche additionnelle 22 pourra par exemple présenter les caractéristiques structurelles suivantes : grains de type 3C SiC, orientés 111, de taille moyenne 1 à 10µm, dopage de type N pour une résistivité finale inférieure ou égale à 0,03 ohm.cm.

L'ensemble formé par la couche intermédiaire 21 et par la couche additionnelle 22 est destiné à former le substrat support 20 de la structure composite 1. Les propriétés électriques, thermiques et mécaniques précitées seront donc assurées par le substrat support 20, remplissant ainsi les spécifications attendues pour des dispositifs de puissance verticaux.

L'épaisseur finale du substrat support 20 est visée dans une gamme typique de 50 microns à 300 microns.

Au cours de la deuxième étape de dépôt, du fait du budget thermique appliqué à la structure formée par le substrat initial 11, la couche intermédiaire 21 et la couche additionnelle 22 croissante, une séparation le long du plan fragile enterré 12 va s'opérer (figure 2e). En effet, les microcavités présentes dans le plan fragile enterré 12 suivent une cinétique de croissance jusqu'à l'initiation d'une onde de fracture qui va se propager sur toute l'étendue du plan fragile enterré 12 et provoquer la séparation entre l'ensemble formé de la couche mince 10, de la couche intermédiaire 21 et de la couche additionnelle 22, et le reste du substrat initial 11'.

Selon une première variante, la séparation s'opère avant que la couche additionnelle 22 n'atteigne son épaisseur cible. Quelle que soit l'épaisseur de couche additionnelle 22 lorsque la séparation s'opère, l'onde de fracture va se propager sur toute l'étendue du plan fragile enterré 12 car la couche intermédiaire 21 présente à elle seule une épaisseur suffisante pour assurer l'effet raidisseur : les cavités ne déforment donc pas la couche sous forme de bullage. Le deuxième dépôt peut ensuite se poursuivre jusqu'à l'atteinte de l'épaisseur cible de la couche additionnelle 22 et l'obtention de la structure composite finale 1 (figure 2f). La somme de l'épaisseur cible de la couche additionnelle 22 et de l'épaisseur de la couche intermédiaire 21 constitue l'épaisseur finale du substrat support 20.

Selon une deuxième variante, la séparation s'opère sensiblement au moment où la couche additionnelle 22 atteint son épaisseur cible.

On comprend bien que l'apparition de la séparation se fera selon les première ou deuxième variantes précitées, en fonction des paramètres d'implantation, de la température du deuxième dépôt et de l'épaisseur visée de la couche additionnelle 22 (qui conditionne la durée du deuxième dépôt).

De manière avantageuse, le procédé de fabrication comprend, avant la première étape et/ou avant la deuxième étape de dépôt, une étape de préparation du substrat initial 11 comportant au moins une séquence de désoxydation de la face avant dudit substrat initial 11. Cette séquence pourra par exemple s'opérer par immersion dans un bain d'acide fluorhydrique (HF) ou par exposition à des vapeurs de HF. L'étape de préparation peut également comprendre des séquences de nettoyage pour éliminer tout ou partie de contaminants particulaires, métalliques ou organiques potentiellement présents sur les faces 11a,11b du substrat initial 11.

Selon un mode de réalisation avantageux, le procédé de fabrication comprend des étapes de finition appliquées à la structure composite finale 1 obtenue à l'issue de la deuxième étape de dépôt. Ces étapes de finition visent en particulier à améliorer la rugosité de la surface libre de la couche mince 10 (face avant de la structure composite finale 1) et éventuellement la rugosité de la face libre de la couche additionnelle 22 (face arrière de la structure composite finale 1). En effet, après la séparation, la face libre de la couche mince 10 présente typiquement une rugosité comprise entre 3 et 6 nm Ra (AFM - scan 20 microns x 20 microns). L'objectif pour la fabrication ultérieure de composants est d'avoir une rugosité inférieure à 1 nm Ra. Concernant la face arrière de la structure composite finale 1, la rugosité à l'issue du deuxième dépôt est typiquement supérieure à 10 nm Ra, voire supérieure à 100 nm Ra ; l'objectif visé est habituellement d'abaisser la rugosité à moins de 3 nm Ra.

Les étapes de finition peuvent en particulier faire appel à des techniques connues de polissage mécano-chimique, appliquées à la face avant de la structure composite finale 1, à sa face arrière, ou aux deux faces simultanément en utilisant des équipements de polissage double-face. Le procédé de polissage pourra être différent entre la face avant et la face arrière, le lissage d'une surface de c-SiC et d'une surface de p-SiC requérant habituellement des consommables différents.

### Exemple :

Selon un exemple non limitatif de mise en oeuvre, la substrat initial 11 fourni à la première étape du procédé de fabrication est une plaquette de c-SiC, de polytype 4H, d'orientation 4.0° par rapport à l'axe <11-20> ± 0.5°, de diamètre 150mm et d'épaisseur 350pm.

Une séquence classique de nettoyage de type RCA (Standard Clean 1 + Standard Clean 2), puis Caro (mélange d'acide sulfurique et d'eau oxygénée), puis HF (acide fluorhydrique), est opérée sur le substrat initial 11 préalablement à la première étape de dépôt. Un dépôt CVD à base de précurseurs chlorés, à une température de 1200°C est effectué sur la face avant 11a du substrat initial 11, générant une couche intermédiaire 21 de 5 microns d'épaisseur, au bout de 6 min (vitesse de dépôt : 50µm/h).

L'implantation d'ions hydrogène est opérée à une énergie de 650 keV et une dose de 6^{E}16 H+/cm², à travers la surface libre de la couche intermédiaire 21. Un plan fragile enterré 12 est ainsi créé à une profondeur d'environ 600 nm dans le substrat initial 11.

Une séquence de nettoyage de type RCA + Caro est opérée sur la structure, de manière à éliminer les potentielles contaminations sur la face libre de la couche intermédiaire 21.

Un deuxième dépôt CVD est effectué sur la couche intermédiaire 21, à une température de 1200°C, pendant 355 minutes, de manière à atteindre une épaisseur cible de 300 microns (somme de l'épaisseur de la couche intermédiaire 21 et de la couche additionnelle 22). La séparation s'opère au niveau du plan fragile enterré 12 au cours du dépôt. A l'issue du deuxième dépôt, la structure composite 1 formée de la couche mince 10 et du substrat support 20 est séparée du reste du substrat initial 11.

Un polissage double face peut être opéré pour restaurer la rugosité de surface de la couche mince 10 et de la face arrière du substrat support 20 (face libre de la couche additionnelle 22).

Bien entendu, l'invention n'est pas limitée aux modes de réalisation et aux exemples décrits, et on peut y apporter des variantes de réalisation sans sortir du cadre de l'invention tel que défini par les revendications.

## Revendications

1. Procédé de fabrication d'une structure composite (1) comprenant une couche mince (10) en carbure de silicium monocristallin disposée sur un substrat support (20) en carbure de silicium poly-cristallin, le procédé comprenant:
- une étape de fourniture d'un substrat initial (11) en carbure de silicium monocristallin,
- une première étape de dépôt à une température supérieure à 1000°C pour former une couche intermédiaire (21) en carbure de silicium poly-cristallin sur le substrat initial (11), la couche intermédiaire (21) présentant une épaisseur supérieure ou égale à 1,5 microns,
- une étape d'implantation ionique d'espèces légères, choisies parmi l'hydrogène et/ou l'hélium, travers la couche intermédiaire (21), pour former un plan fragile enterré (12) dans le substrat initial (11), délimitant la couche mince (10) entre ledit plan fragile enterré (12) et la couche intermédiaire (21),
- une deuxième étape de dépôt à une température supérieure à 1000°C pour former une couche additionnelle (22) en carbure de silicium poly-cristallin sur la couche intermédiaire (21), ladite couche intermédiaire (21) et la couche additionnelle (22) formant le substrat support (20), une séparation le long du plan fragile enterré (12) s'opérant au cours de la deuxième étape de dépôt.

2. Procédé de fabrication selon la revendication précédente, dans lequel la première étape et la deuxième étape de dépôt sont réalisées par dépôt chimique en phase vapeur, à une température comprise entre 1000°C et 1600°C, préférentiellement comprise entre 1200°C et 1600°C.

3. Procédé de fabrication selon la revendication précédente, dans lequel la première étape et/ou la deuxième étape de dépôt sont réalisées à partir de précurseurs chlorés.

4. Procédé de fabrication selon l'une des revendications précédentes, dans lequel, à l'issue de la première étape de dépôt, la couche intermédiaire (21) présente une épaisseur supérieure ou égale à 3 microns, voire une épaisseur supérieure ou égale à 5 microns.

5. Procédé de fabrication selon l'une des revendication précédentes, dans lequel l'implantation d'ions hydrogène est opérée à une énergie comprise entre 260 keV et 2000 keV, et à une dose comprise entre 5E16/cm² et 1^{E}17/cm².

6. Procédé de fabrication selon l'une des revendications précédentes, comprenant, avant la première étape de dépôt, une étape de préparation du substrat initial (11) comportant au moins une désoxydation d'une surface avant dudit substrat initial (11).

## Patentansprüche

1. Verfahren zum Herstellen einer Verbundstruktur (1), umfassend eine dünne Schicht (10) aus monokristallinem Siliciumcarbid, das auf einem Trägersubstrat (20) aus polykristallinem Siliciumcarbid angeordnet ist, das Verfahren umfassend:
- einen Schritt eines Bereitstellens eines ursprünglichen Substrats (11) aus monokristallinem Siliciumcarbid,
- einen ersten Schritt eines Abscheidens bei einer Temperatur von über 1000 °C, um eine Zwischenschicht (21) aus polykristallinem Siliciumcarbid auszubilden, auf dem ursprünglichen Substrat (11), wobei die Zwischenschicht (21) eine Dicke von größer als oder gleich 1,5 Mikrometer aufweist,
- einen Schritt eines lonenimplantierens von leichten Spezies, die aus Wasserstoff und/oder Helium ausgewählt sind, durch die Zwischenschicht (21), um eine verdeckte brüchige Ebene (12) in dem ursprünglichen Substrat (11) auszubilden, die die dünne Schicht (10) zwischen der verdeckten spröden Ebene (12) und der Zwischenschicht (21) begrenzt,
- einen zweiten Schritt zum Abscheiden bei einer Temperatur über 1000 °C, um eine zusätzliche Schicht (22) aus polykristallinem Siliciumcarbid auszubilden, auf der Zwischenschicht (21), wobei die Zwischenschicht (21) und die zusätzliche Schicht (22) das Trägersubstrat (20) ausbilden, wobei während des zweiten Abscheidungsschritts eine Trennung entlang der verdeckten spröden Ebene (12) erfolgt.

2. Herstellungsverfahren nach dem vorstehenden Anspruch, wobei der erste Schritt und der zweite Schritt des Abscheidens durch chemische Abscheidung in der Dampfphase bei einer Temperatur zwischen 1000 °C und 1600 °C, vorzugsweise zwischen 1200 °C und 1600 °C, durchgeführt werden.

3. Herstellungsverfahren nach dem vorstehenden Anspruch, wobei der erste Schritt und/oder der zweite Schritt des Abscheidens aus chlorierten Zwischenstoffen durchgeführt werden.

4. Herstellungsverfahren nach einem der vorstehenden Ansprüche, wobei die Zwischenschicht (21) nach dem ersten Abscheidungsschritt eine Dicke von größer als oder gleich 3 Mikrometer, sogar eine Dicke von größer als oder gleich 5 Mikrometer, aufweist.

5. Herstellungsverfahren nach einem der vorstehenden Ansprüche, wobei das Implantieren von Wasserstoffionen mit einer Energie zwischen 260 keV und 2000 keV und einer Dosis zwischen 5E16/cm² und 1^{E}17/cm² vorgenommen wird.

6. Herstellungsverfahren nach einem der vorstehenden Ansprüche, umfassend, vor dem ersten Abscheidungsschritt, einen Schritt eines Vorbereitens des ursprünglichen Substrats (11), der mindestens eine Reduktion einer vorderen Oberfläche des ursprünglichen Substrats (11) umfasst.

## Claims

1. Method for producing a composite structure (1) comprising a thin layer (10) made of monocrystalline silicon carbide arranged on a support substrate (20) made of polycrystalline silicon carbide, the method comprising:
- a step of providing an initial substrate (11) made of monocrystalline silicon carbide,
- a first deposition step at a temperature greater than 1000°C to form an intermediate layer (21) made of polycrystalline silicon carbide on the initial substrate (11), the intermediate layer (21) having a thickness greater than or equal to 1.5 microns,
- a step of implanting, by means of ion implantation, light species, chosen from hydrogen and/or helium, through the intermediate layer (21), to form a buried brittle plane (12) in the initial substrate (11), delimiting the thin layer (10) between said buried brittle plane (12) and the intermediate layer (21),
- a second deposition step at a temperature greater than 1000°C to form an additional layer (22) made of polycrystalline silicon carbide on the intermediate layer (21), said intermediate layer (21) and the additional layer (22) forming the support substrate (20), a separation along the buried brittle plane (12) occurring during the second deposition step.

2. Production method according to the preceding claim, wherein the first step and the second deposition step are carried out by chemical vapor deposition at a temperature of between 1000°C and 1600°C, preferably of between 1200°C and 1600°C.

3. Production method according to the preceding claim, wherein the first step and/or the second deposition step are carried out from chlorinated precursors.

4. Production method according to any of the preceding claims, wherein, at the end of the first deposition step, the intermediate layer (21) has a thickness greater than or equal to 3 microns, or even a thickness greater than or equal to 5 microns.

5. Production method according to any of the preceding claims, wherein the implantation of hydrogen ions is carried out at an energy of between 260 keV and 2000 keV, and at a dose of between 5^{E}16/cm²and 1^{E}17/cm ².

6. Production method according to any of the preceding claims, comprising, before the first deposition step, a step of preparing the initial substrate (11) comprising at least one deoxidation of a front surface of said initial substrate (11).
